# NEUE EUROPÄISCHE PATENTSCHRIFT

(11) **EP 0 558 712 B2**
(45) Veröffentlichungstag und Bekanntmachung des Hinweises auf die Entscheidung über den Einspruch: **07.04.2010**
(45) Hinweis auf die Patenterteilung: 11.12.1996
(21) Anmeldenummer: 92918773.0
(22) Anmeldetag: 09.09.1992
(51) Int. Cl.: H05K 7/20

(54) **ELEKTRISCHES GERÄT, INSBESONDERE SCHALT- UND STEUERGERÄT FÜR KRAFTFAHRZEUGE**
ELECTRICAL DEVICE, ESPECIALLY SWITCHING AND CONTROL DEVICE FOR MOTOR VEHICLES
DISPOSITIF ELECTRIQUE, NOTAMMENT DISPOSITIF DE COMMANDE ET DE COMMUTATION POUR VEHICULES A MOTEUR

(30) Priorität: 21.09.1991 DE 4131515; 11.07.1992 DE 4222838
(43) Veröffentlichungstag der Anmeldung: 08.09.1993
(73) Patentinhaber: ROBERT BOSCH GMBH, 70442 Stuttgart (DE)
(72) Erfinder: JAKOB, Gert, D-7000 Stuttgart 50 (DE); ZIMMERMANN, Joachim, D-7141 Schwieberdingen (DE); HORN, Friedrich, D-8802 Lichtenau (DE); RUMMEL, Hans, D-8800 Ansbach (DE); SUTTER, Thomas, D-7141 Oberriexingen (DE); KARR, Dieter, D-7533 Tiefenbronn (DE); SCHUPP, Karl, D-7530 Pforzheim (DE); NEUHAUS, Dieter, D-7157 Sulzbach (DE); HUSSMANN, Dieter, D-7141 Steinheim (DE); JARES, Peter, D-7032 Sindelfingen (DE)
(86) Internationale Anmeldenummer: PCT/DE1992/000721
(87) Internationale Veröffentlichungsnummer: WO 1993/006705

(56) Entgegenhaltungen:
- EP-A- 0 308 296
- DE-A- 2 226 395
- DE-A- 3 115 017
- DE-A- 3 305 167
- DE-A- 3 437 774
- DE-A- 3 832 856
- DE-U- 8 114 325
- FR-A1- 2 223 933
- US-A- 3 631 325
- US-A- 4 339 260
- US-A- 4 475 145
- US-A- 4 811 165

## Beschreibung

### Stand der Technik

Die Erfindung geht aus von einem elektrischen Gerät nach der Gattung des Hauptanspruchs.

Bei derartigen Geräten, wie sie beispielsweise aus der EP 0 308 296 A1 bekannt sind, ist eine aus einer Kunststoffplatte bestehende Schaltungskarte bekannt, die auf beiden Seiten Kupferkaschierungen aufweist. Auf einer Seite werden elektronische Komponenten montiert, die andere Seite ist für die Lötverbindungen vorgesehen. Beide Seiten sind mit Leiterbahnen und mit Bauelementen versehen. Zwei wärmeleitende Bereiche sind auf der zur Montage der Bauelemente dienenden Seite und auf der für die Lötverbindungen dienenden Seite vorgesehen. Die Leiterbahnen und die wärmeleitenden Bereiche sind mit denselben Verfahrensschritten hergestellt. Ein Kühlelement ist auf der Leiterplatte befestigt, wobei die metallischen Bereiche mit einem oder mehreren Bauelementen thermisch gekoppelt werden. Die Schichtdicke der zur Wärmeableitung dienenden Bereiche ist größer als die Schichtdicke der zur elektrischen Kontaktierung dienenden Leiterbahnen.

Demgegenüber ist vorgesehen die Wärmeableitung zu verbessern.

### Vorteile der Erfindung

Das erfindungsgemäße elektrische Gesät mit den Merkmalen des Hauptanspruchs hat demgegenüber den Vorteil, daß, die wärmeleitende Schicht bis an den Rand der Leiterplatte reicht und daß das Kühlelement am Rand der Leiterplatte auf der wärmeleitenden Schicht aufliegt, wodurch die Wärmeabführung verbessert ist. Durch die gute Wärmeabführung ist auch eine höhere Umgebungstemperatur möglich, wie sie zum Beispiel im Motorraum eines Kraftfahrzeugs herrscht. Das Gehäuse des elektrischen Gerätes kann weiterhin mit einer geringen Anzahl von Fertigungsschritten automatisch bestückt und verlötet werden.

### Zeichnung

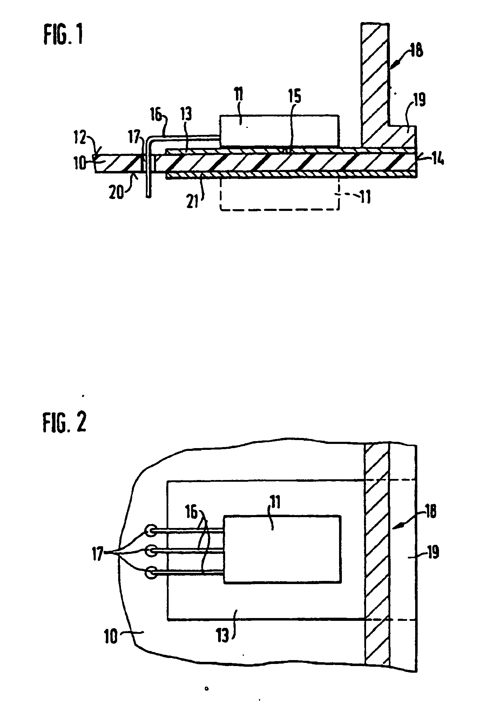

Zwei Ausführungsbeispiele der Erfindung sind in der nachfolgenden Beschreibung und Zeichnung näher erläutert. Letztere zeigt in Figur 1 ein nur teilweise dargestelltes Steuergerät im Längsschnitt und in Figur 2 eine Draufsicht auf eine Leiterplatte mit geschnitten dargestelltern Gehäuse.

### Beschreibung des Ausführungsbeispiels

In den Figuren 1 und 2 ist mit 10 die Leiterplatte eines elektronischen Steuergerätes bezeichnet, die eine nicht näher dargestellte Schaltung trägt. Zu dieser Schaltung gehört auch ein sich in Betrieb stark erwärmendes Leistungsbauelement 11, dessen Wärme abzuleiten ist.

Auf die Oberseite 12 der Leiterplatte 10 ist eine Schicht 13 aus gut wärmeleiltendem Material aufgebracht, die bis an den Rand 14 der Leiterplatte reicht. Die Schicht 13 aus gut wärmeleitendem Material ist vorzugsweise metallisch und kann beispielsweise eine entsprechend ausgebildete Leiterbahn, eine Alschirmfläche zur Verbesserung der elektromagnetischen Verträglichkeit (EMV), Laminat, eine Kupferkaschierung oder ähnliches sein.

Auf dieser wärmeleitenden Schicht 13 liegt das Leistungsbauelement 11 mit seiner Rückseite 15 (größte Fläche) auf und ist auf geeignete Weise betestigt, zum Beispiel verklebt, gelötet, geschraubt. Die aufliegende Rückseite 15 des Leistungsbauelementes 11 ist kleiner als die Grundfläche der wärmeleitenden Schicht 13.

Die Anschlußelektroden 16 des Leistungsbauelementes 11 verlaufen zunächst parallel zur Leiterplatte 10, ohne die wärmeleitende Schicht 13 zu berühren, und sind außerhalb derselben abgebogen und in entsprechende Lötöffnungen 17 der Leiterplatte geführt. Durch Verlöten wird das Leistungsbauelement mit der Schaltung verbunden.

Auf die Oberseite 12 der Leiterplatte 10 ist ein haubenartiger Deckel 18 aufgesetzt, dessen umlaufender Rand 19 am Rand der Leiterplatte 10 auf derselben und damit auch auf der wärmeleitenden Schicht 13 aufliegt. Der Deckel 18 bzw. dessen Rand 19 ist auf geeignete Weise mit der Leiterplatte 10 verbunden, zum Beispiel geklebt, geschraubt oder verlötet.

Der Deckel 18 ist zumindest im Bereich der wärmeleitenden Schicht 13 aus einem wärmeleitenden Material vorzugsweise einem Metall, gefertigt und dient als Kühlfläche für das Leistungsbauelement 11.

Die vom Leistungsbauelement 11 abzuleitende Wärme wird also über die wärmeleitende Schicht 13 zu einer Kühlfläche, dem Deckel 17, geleitet. Eine aufwendige Montage des Leistungsbauelementes auf oder an einer speziellen formangepaßten Kühlfläche entfällt. Die Kühlfläche ist demzufolge unabhängig von der Form des Leistungsbauelementes, das heißt die Form das Leistungsbauelementes beeinflußt weder die Form noch die Lage der Kühlfläche. Darüberhinaus braucht zwischen Leistungsbauelement und Kühlfläche keine direkte Nachbarschaftslage zu bestehen.

Ist die Leiterplatte 10 - wie in Figur 1 gestrichelt dargestellt - als Zweitagenleiterplatte ausgeführt, kann auch die Unterseite 20 entsprechend mit Leistungsbauelementen 11 bestückt werden. Diese liegen dann ebenfalls auf einer wärmeleitenden Schicht 21 auf, über die die abzuleitende Wärme an eine nicht dargestellte Kühlfläche geführt wird.

Zur Verbesserung des Wärmeübergangs zwischen der wärmeleitenden Schicht 13 bzw. 21 und der Kühlfläche kann die Oberfläche der wärmeleitenden Schicht entsprechend strukturiert werden. Durch geeignete Maßnahmen kann beispielsweise eine Lotschicht oder andere wärmeleitende Schicht in Gitterstruktur aufgeprägt werden, zum Beispiel durch ein Reflow-Lötverfahren.

Zur weiteren Verbesserung des Wärmeübergangs ist eine großflächige Kontaktierung zwischen wärmeleitender Schicht 13 und Kühlfläche vorteilhaft.

Sind mehrere Leistungsbauelemente 11 auf einer Seite 12 bzw. 20 der Leiterplatte nebeneinander angeordnet, sollten die jeweiligen metallischen Schichten 13 gegeneinander isoliert sein, das heißt einander nicht berühren.

Ist die Kühlfläche wie im Ausführungsbeispiel dargestellt, der Deckel eines Gehäuses oder ein - nicht dargestelltes - frei zugängliches Kühlelement (z.B. Kühlwinkel), sind diese vorteilhafter Weise gegen die wärmeleitende Schicht 13 elektrisch isoliert. Dazu kann entweder die Kühlfläche im Bereich der Kontaktstelle mit einer Isolationsschicht versehen sein, zum Beispiel einer Eloxalschicht, einem Lack oder ähnlichem. Das entsprechende Kühlelement kann dann auch zur Kühlung mehrerer Leistungsbauelemente genutzt werden.

Es ist auch möglich die wärmeleitende Schicht 13 zumindest im Bereich der Kühlfläche mit einer Isolationsschicht zu versehen.

Im Gegensatz dazu kann aber auch bei bestimmten Anwendungställen, zum Beispiel zur Verbesserung der elektromagnetischen Verträglichkeit, eine elektrisch leitende Verbindung zwischen Kühlfläche und wärmeleitender Schicht 13 sinnvoll sein. Dazu werden diese dann ohne isolierung zusammengefügt

Wird als wärmeleitende Schicht zum Beispiel eine entsprechend breit ausgebildete Leiterbahn oder eine Abschirmfläche genutzt, kann diese zur Verbesserung der Wärmeleitfähigkeit entsprechend dicker (größere Schichtdicke) ausgebildet sein.

Im Verdrahtungsbereich der Leiterplatte wird dazu eine Lederschicht mit einer Stärke von z. B. 30 µm aufgetragen Damit können dann Leiterbahnen mit Breiten unter 200 µm und etwa gleich breiten Abständen zwischen den Leiterbahnen gefertigt werden.

In den Bereichen, in denen elektrische Bauelemente wärmeleitend mit den Leiterbahnen verbunden werden sollen, wird die Schichtdicke erhöht auf Dicken über 50 µm, vorzugsweise auf Schichtdicken von 100 µm bis 200 µm.

Zur weiteren Verbesserung der Wärmeleitfähigkeit kann die Leiterplatte 10 auf beiden Seiten (Seite 12 oder Seite 20) mit wärmeleitenden Schichten versehen sein, die über eine an sich bekannte Durchkontaktierung miteinander verbunden sind Damit werden parallele Wärmeableitwege geschaffen.

Wird die Leiterplatte 10 im Bereich der wärmeleitenden Schicht mit SMD-Bauteilen (SMD = surface mounted device) bestückt, liegen die Oberfläche der wärmeleitenden Schicht 13 und die des entsprechenden Leiterbahnenabschnittes für eine gute Montage und Kontaktierung vorzugsweise in einer Ebene.

Ist die Kühlfläche, wie im Ausführungsbeispiel dargestellt, der Deckel eines Gehäuses, kann dieser so ausgebildet sein, daß gleichzeitig eine elektromagnetische Schirmung der abgedeckten Schaltung erfolgt (Verbesserung der elektromagnetischen Verträglichkeit, EMV). Dieser Deckel wird dann als metallische bzw. metallisierte Box ausgebildet, die die entsprechenden Leiterplattenbereiche abdeckt. Diese metallische Box kann dann beispielsweise die gesamte Leiterplattenfläche abdecken und an den Rändern der Leiterplatte aufliegen. Dort erfolgt eine elektrische und wärmeleitende Kontaktierung. Es ist auch möglich, diese Box so auszubilden, daß sie die Leiterplatte nur in dem Bereich überdeckt, in dem empfindliche Bauelemente angeordnet sind, d. h. Bauelemente, die im Hinblick auf die elektromagnetische Verträglichkeit der Schaltung abgeschirmt werden müssen. Dabei können die zu kühlenden Leistungsbauelemente innerhalb oder außerhalb der Box angeordnet werden.

Um diese Box mechanisch stabil und gut leitend mit der Leiterplatte zu verbinden, können an deren Unterseite Verbindungslaschen angebracht werden, die durch entsprechende Öffnungen der Leiterplatte ragen oder an deren Rändern vorbeigeführt werden. Die Box wird dazu nach dem Löten der Leiterplatten-Oberseite auf diese aufgesetzt, und die Verbindungslaschen werden umgebogen oder verlötet. Diese Verbindungslaschen können darüber hinaus zur Fixierung eines entsprechenden Unterteils (ebenfalls eine EMV-Box) genutzt werden.

## Patentansprüche

1. Elektrisches Gerät, insbesondere Schalt- oder Steuergerät für Kraftfahrzeuge, mit einer eine elektronische Schaltung tragenden Leiterplatte (10), auf der Leiterbahnen zur elektrischen Kontaktierung und mindestens ein zu kühlendes Leistungsbauelement (11) angeordnet sind, wobei auf die Leiterplatte (10) zumindest im Bereich des Leistungsbauelements (11) eine wärmeleitende Schicht (13, 21) aufgebracht ist, auf der das Leistungsbauelement (11) aufliegt und wobei die wärmeleitende Schicht (13, 21) eine Leiterbahn ist, die die Wärme von dem Leistungsbauelement (11) direkt zu einem Kühlelement (18) ableitet, wobei die Schichtdicke der Leiterbahnen in den der Wärmeleitung dienenden Bereichen eine größere Dicke aufweist als in den der elektrischen Kontaktierung dienenden Bereichen, **dadurch gekennzeichnet, daß** die wärmeleitende Schicht (13) bis an den Rand (14) der Leiterplatte (10) reicht und daß das Kühlelement (18) am Rand (14) der Leiterplatte (10) auf der wärmeleitenden Schicht (13) aufliegt.

2. Elektrisches Gerät nach Anspruch 1, **dadurch gekennzeichnet, daß** die wärmeleitende Schicht (13, 21) eine unterschiedliche Dicke aufweist.

3. Elektrisches Gerät nach Anspruch 1, **dadurch gekennzeichnet, daß** die Schichtdicke im Bereich der wärmeleitenden Schicht (13) größer als 70 µm ist, und daß die Schichtdicke der Leiterbahnen in den im wesentlichen nicht wärmeleitenden Bereichen etwa 30 µm beträgt.

4. Elektrisches Gerät nach einem der Ansprüche 1 bis 3, **dadurch gekennzeichnet, daß** das Leistungsbauelement (111) mit einer seiner Flächen, vorzugsweise der größten Fläche (15) flächig auf der wärmeleitenden Schicht (13, 21) aufliegt.

5. Elektrisches Gerät nach einem der Ansprüche 1 bis 4, **dadurch gekennzeichnet, daß** das Kühlelement (18, 19) Teil eines die Leiterplatte (10) aufnehmenden Gehäuses ist.

6. Elektrisches Gerät nach einem der Ansprüche 1 bis 5, **dadurch gekennzeichnet, daß** das Kühlelement ein freistehender metallischer Körper ist.

7. Elektrisches Gerät nach einem der Ansprüche 1 bis 6, **dadurch gekennzeichnet, daß** die wärmeleitende Schicht (13, 21) und die Kühlfläche (18, 19) elektrisch gegeneinander isoliert sind.

8. Elektrisches Gerät nach einem der Ansprüche 1 bis 7, **dadurch gekennzeichnet, daß** auf die Leiterplatte (10) beidseitig wärmeleitende Schichten (13, 21) aufgebracht sind.

9. Elektrisches Gerät nach Anspruch 8, **dadurch gekennzeichnet, daß** die wärmeleitenden Schichten (13, 21) über Durchkontektierungen verbunden sind.

10. Elektrisches Gerät nach einem der Ansprüche 1 bis 9, **dadurch** gekennzeiehnet, daß das Kühlelement Teil eines elektromagnetisch abschirmenden Gehäusebauteils ist.

11. Elektrisches Gerät nach Anspruch 10, **dadurch gekennzeichnet, daß** die zu kühlenden Leistungsbauelemente (11) innerhalb des elektromagnetisch abschirmenden Gehäusebauteils angeordnet ist.

12. Elektrisches Gerät nach Anspruch 5, **dadurch gekennzeichnet, daß** die zu kühlenden Leistungsbauelemente (11) außerhalb des elektromagnetisch beschirmenden Gehäusebauteils angeordnet sind.

## Claims

1. Electrical device, in particular a switching or control unit for motor vehicles, with a printed circuit board (10) carrying an electronic circuit, on which printed circuit board are arranged conductor tracks for electrical contact-connection and at least one power component (11) to be cooled, wherein the printed circuit board (10) has at least in the vicinity of the power component (11) a heat conductive layer (13, 21) applied to it on which the power component (11) rests, and wherein the heat conductive layer (13, 21) is a conductor track which conducts the heat away from the power component (11) directly to a cooling element (18), wherein the layer thickness of the conductor tracks in the regions serving for heat conduction is greater than in the regions serving for electrical contact-connection, **characterized in that** the heat conductive layer (13) extends close to the edge (14) of the printed circuit board (10), and **in that** the cooling element (18) at the edge (14) of the printed circuit board (10) rests on the heat conductive layer (13).

2. Electrical device according to Claim 1, **characterized in that** the heat conductive layer (13, 21) has a varying thickness.

3. Electrical device according to Claim 1, **characterized in that** the layer thickness in the region of the heat conductive layer (13) is greater than 70 µm, and **in that** the layer thickness of the conductor tracks in the essentially non-heat-conductive regions is approximately 30 µm.

4. Electrical device according to any one of Claims 1 to 3, **characterized in that** the power component (11) rests with one of its faces, preferably the largest face (15) flat on the heat conductive layer (13, 21).

5. Electrical device according to any one of Claims 1 to 4, **characterized in that** the cooling element (18, 19) is part of a housing which accommodates the printed circuit board (10).

6. Electrical device according to any one of Claims 1 to 5, **characterized in that** the cooling element is a freestanding metallic body.

7. Electrical device according to any one of Claims 1 to 6, **characterized in that** the heat conductive layer (13, 21) and the cooling surface (18, 19) are electrically insulated from each other.

8. Electrical device according to any one of Claims 1 to 7, **characterized in that** heat conductive layers (13, 21) are applied to both sides of the printed circuit board (10).

9. Electrical device according to Claim 8, **characterized in that** the heat conductive layers (13, 21) are connected via through-contacts.

10. Electrical device according to any one of Claims 1 to 9, **characterized in that** the cooling element is part of an electromagnetically screening housing part.

11. Electrical device according to Claim 10, **characterized in that** the power components (11) to be cooled are arranged within the electromagnetically screening housing part.

12. Electrical device according to Claim 5, **characterized in that** the power components (11) to be cooled are arranged outside the electromagnetically screening housing part.

## Revendications

1. Appareil électrique, en particulier appareil de branchement ou de commande pour véhicules automobiles avec une plaque de circuits imprimés (10) portant un circuit électronique, sur laquelle sont disposés des pistes conductrices pour assurer le contact électrique et au moins un composant de puissance (11) à refroidir, une couche thermoconductrice (13, 21) étant déposée sur la plaque de circuits imprimés (10) au moins dans la zone du composant de puissance (11), le composant de puissance (11) reposant sur ladite couche, et la couche thermoconductrice (13, 21) étant une piste conductrice qui évacue la chaleur du composant de puissance (11) directement vers un élément de refroidissement (18), l'épaisseur de couche des pistes conductrices dans les zones servant à la conduction thermique étant plus importante que dans les zones servant à assurer le contact électrique, **caractérisé en ce que** la couche thermoconductrice (13) s'étend jusqu'au bord (14) de la plaque de circuits imprimés (10) et **en ce que** l'élément de refroidissement (18) s'applique au bord (14) de la plaque de circuits imprimés (10) sur la couche thermoconductrice (13).

2. Appareil électrique selon la revendication 1, **caractérisé en ce que** la couche thermoconductrice (13, 21) a une épaisseur différente.

3. Appareil électrique selon la revendication 1, **caractérisé en ce que** l'épaisseur de couche dans la zone de la couche thermoconductrice (13) est supérieure à 70 µm et **en ce que** l'épaisseur de couche des pistes conductrices dans les zones sensiblement non conductrices vaut environ 30 µm.

4. Appareil électrique selon l'une quelconque des revendications 1 à 3, **caractérisé en ce que** le composant de puissance (11) repose par l'une de ses faces, de préférence la face (15) la plus grande à plat sur la couche thermoconductrice (13, 21).

5. Appareil électrique selon l'une quelconque des revendications 1 à 4, **caractérisé en ce que** l'élément de refroidissement (18, 19) fait partie d'un boîtier dans lequel est logée la plaque de circuits imprimés (10).

6. Appareil électrique selon l'une quelconque des revendications 1 à 5, **caractérisé en ce que** l'élément de refroidissement est un corps métallique isolé.

7. Appareil électrique selon l'une quelconque des revendications 1 à 6, **caractérisé en ce que** la couche thermoconductrice (13, 21) et la surface de refroidissement (18, 19) sont isolées électriquement l'une par rapport à l'autre.

8. Appareil électrique selon l'une quelconque des revendications 1 à 7, **caractérisé en ce que** l'on met sur la plaque imprimée (10) des deux côtés des couches thermoconductrices (13, 21).

9. Appareil électrique selon la revendication 8, **caractérisé en ce que** les couches thermoconductrices (13, 21) sont reliées par des trous métallisés.

10. Appareil électrique selon l'une quelconque des revendications 1 à 9, **caractérisé en ce que** l'élément de refroidissement fait partie d'un composant du boîtier blindé électromagnétiquement.

11. Appareil électrique selon la revendication 10, **caractérisé en ce que** les composants de puissance à refroidir (11) sont disposés à l'intérieur du composant du boîtier qui est blindé électromagnétiquement.

12. Appareil électrique selon la revendication 5, **caractérisé en ce que** les composants de puissance à refroidir (11) sont disposés en dehors du composant du boîtier électromagnétiquement blindé.
